# EUROPÄISCHE PATENTSCHRIFT

(11) **EP 0 893 696 B1**
(45) Veröffentlichungstag und Bekanntmachung des Hinweises auf die Patenterteilung: **10.09.2008**
(21) Anmeldenummer: 98112099.1
(22) Anmeldetag: 01.07.1998
(51) Int. Cl.: G01R 15/18

(54) **Einrichtung zum Erfassen eines Stroms**
Arrangement for measuring a current
Dispositif pour mesurer un courant

(30) Priorität: 24.07.1997 DE 19731790
(43) Veröffentlichungstag der Anmeldung: 27.01.1999
(73) Patentinhaber: ROBERT BOSCH GMBH, 70442 Stuttgart (DE)
(72) Erfinder: Weber, Rupert, 63936 Schneeberg (DE); Cohrs, Reinhard, 64711 Erbach (DE); Hoefflin, Eberhard, 64711 Erbach (DE)
(74) Vertreter: Thürer, Andreas

(56) Entgegenhaltungen:
- EP-A- 0 710 844
- DE-A- 3 401 594
- DE-A- 3 626 328
- DE-A- 4 134 461
- US-A- 4 716 364
- PATENT ABSTRACTS OF JAPAN vol. 098, no. 008, 30. Juni 1998 & JP 10 082816 A (YAZAKI CORP), 31. März 1998

## Beschreibung

### Stand der Technik

Die Erfindung geht aus von einer Stromerfassungseinrichtung nach der Gattung des Hauptanspruchs. Bekannte Einrichtungen bestehen aus einem stromführenden Leiter, um den herum eine Spule angeordnet ist. Ein in dem Leiter fließender Wechselstrom induziert in die Spule eine Spannung, die proportional der zeitlichen Änderung des Stromes ist. Geeignete Auswertung der Induktionsspannung liefert eine Aussage über den im Leiter fließenden Strom. Einrichtungen, welche diese Art der Strommessung durchführen, sind im Handel als Komplettbauelemente erhältlich und leicht in elektronische Schaltungen integrierbar. Es ist dafür lediglich ein Anschluß für den zu messenden Strom, sowie ein weiterer Anschluß für die Herausführung des Meßsignales vorzusehen. Unbefriedigend an solchen bekannten Strommeßbauelementen ist ihr vergleichsweise großer Raumbedarf, welcher die Miniaturisierung von Schaltungen begrenzt, sowie ihr durch die Ausführung als abgeschlossene Baugruppe bedingter hoher Preis.

DE-A1-36 26 328 beschreibt eine Vorrichtung zur potential getrennten Messwerterfassung von Wechselströmen. Sie wird in dem Kraftfeld eines stromdurchflossenen Leiters, auf einer isolierenden Substratfläche einer Leiterbahnschleife angeordnet.

US-A-5 621 377 beschreibt eine Messanordnung zur Stromerfassung unter Verwendung von magneto-resistiven Widerständen.

Es ist Aufgabe der Erfindung, eine Stromerfassungseinrichtung anzugeben, welche möglichst wenig Bauraum beansprucht und dabei kostengünstig ist.

Diese Aufgabe wird gelöst durch eine Einrichtung mit den kennzeichnenden Merkmalen des Hauptanspruchs. Erfindungsgemäß ist die Erfassungseinrichtung flächig auf den Oberflächen einer Leiterplatte ausgebildet und benötigt keinen Tiefenbauraum. Die Herstellung der eigentlichen Meßanordnung erfolgt durch Ausbildung einer Leiterbahnstruktur und ist dadurch außerordentlich kostengünstig. Ein besonderer Vorteil der erfindungsgemäßen Erfassungseinrichtung ist, daß zusätzliche Maßnahmen zur galvanischen Trennung von stromführendem Leiter und der Meßanordnung nicht erforderlich sind. Dadurch wird die Fertigung weiter vereinfacht und flexibilisiert. Die Ausgestaltung als Leiterbahnstruktur bietet zudem die für Leiterbahnen typischen Vorteile hinsichtlich thermischer Unempfindlichkeit, Kontaktsicherheit, Unempfindlichkeit gegen mechanische Beschädigung und gute Reproduzierbarkkeit der mechanischen Anordnung.

Unter Bezugnahme auf die Zeichnung wird die Erfindung nachfolgend anhand von Ausführungsbeispielen näher erläutert.

### Zeichung

Es zeigen
Figur 1 das zugrundeliegende Erfassungsprinzip,
Figur 2 einen Querschnitt durch eine Erfassungseinrichtung,
Figur 3 den Aufbau einer Überwachungsschaltung, Figur 4 eine Nutzung der Erfassungseinrichtung in einer Schweißanlage.

### Beschreibung

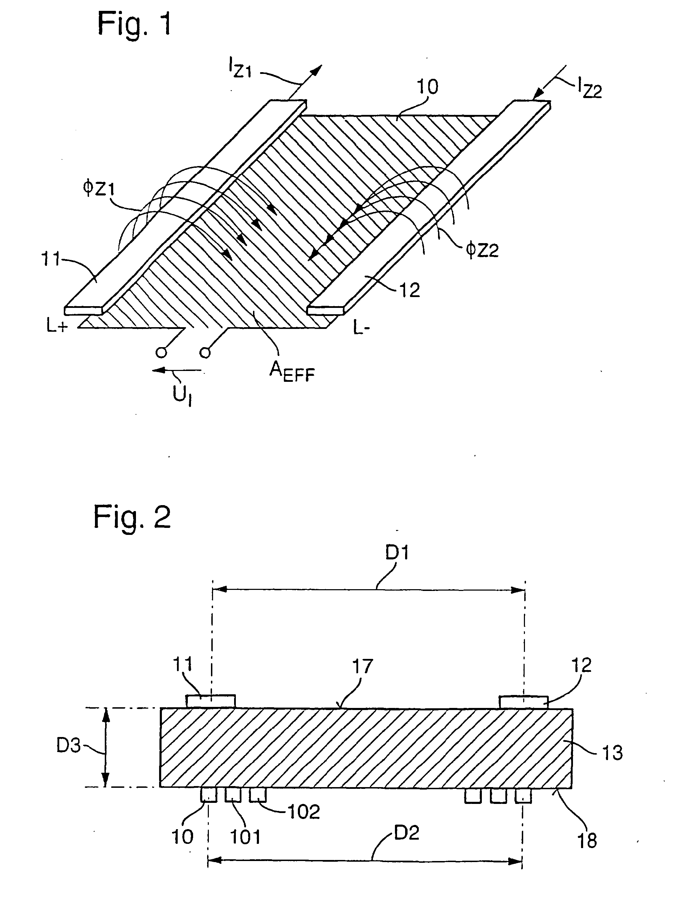

Figur 1 veranschaulicht das der vorgeschlagenen Einrichtung zugrundeliegende physikalische Prinzip. Durch die beiden Leiter 11, 12 fließen in entgegengesetzter Richtung jeweils Wechselströme I_{Z1}, I_{Z2} welche ein die Leiter jeweils umgebendes Magnetfeld Φ_{Z1}, Φ_{Z2} mit sich führen. Unter den Leitern 11, 12 befindet sich eine Leiterschleife 10 so, daß sie von den Magnetfeldern Φ_{Z1}, Φ_{Z2} durchdrungen wird. Durch eine, durch Änderung der Ströme I_{Z1}, I_{Z2} bewirkte Änderung der Magnetfelder Φ_{Z1}, Φ_{Z2}, wird in die Leiterschleife 10 eine Spannung Uᵢ induziert. Sie ist ein Maß für den in den Leitern 11, 12 fließenden Wechselstrom.

Figur 2 zeigt einen Querschnitt durch eine das in Figur 1 wiedergegebene Prinzip nutzende Erfassungseinrichtung. Auf einer ersten, hier als Oberseite bezeichneten Oberfläche 17 einer Leiterplatte 13 sind in einem Abstand D1 voneinander zwei Leiterbahnen 11 und 12 aufgebracht. Auf der gegenüberliegenden, hier als Unterseite bezeichneten Oberfläche 18 der Leiterplatte 13 ist eine Leiterschleife 10 aufgebracht. Zur Vergrößerung des Meßsignales ist sie zweckmäßig in sich mehrfach gewunden, wie durch die Windungen 101, 102 angedeutet. Der Außendurchmesser D2 der Leiterschleife 10, 101, 102 ist auf den Abstand D1 der Leiterbahnen 11, 12 auf der Oberseite 17 der Leiterplatte 13 abgestimmt. Er ist abhängig von D3 so gewählt, daß die Windungen der Leiterschleife 10, 101, 102 sicher von dem die Leiterbahnen 11, 12 umgebenden Magnetfeld durchdrungen werden.

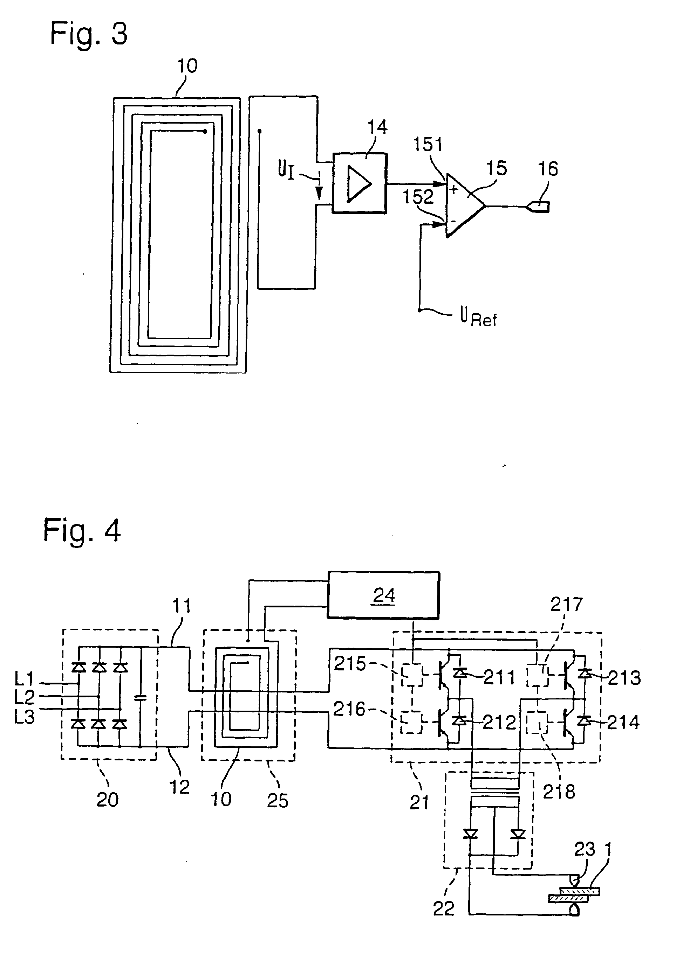

Die in die Leiterschleife 10 induzierte Spannung Uᵢ ist, wie in Figur 3 angedeutet, welche eine Leiterschleife 10 in Draufsicht wiedergibt, zur Verstärkung einem Verstärker 14 zugeführt. Das verstärkte Meßsignal Uᵢ ist dem ersten Eingang 151 eines Komparators 15 zugeführt. Auf dessen zweiten Eingang 152 ist eine Referenzspannung U_{ref} geschaltet, welche einem maximalen Wert für die in den Leitern 11, 12 auftretenden Stromänderungen dI_{Z1} /dt, dI_{Z2}/dt entspricht. Am Ausgang 16 liegt so ein Signal an, welches darüber Auskunft gibt, ob die in den Leitern 11, 12 auftretenden Stromänderungen dI_{Z1}/dt, dI_{Z2}/dt in einem vordefinierten Normalbereich liegen oder einen Grenzwert überschreiten.

Figur 4 zeigt eine Anwendung der vorbeschriebenen Erfassungseinrichtung in einer nach dem Frequenzumrichterprinzip arbeitenden Schweißanlage. Sie zeigt an ihrer Eingangsseite eine Gleichrichtereinheit 20 zur Überführung eines dreiphasigen Eingangswechselstromes L1, L2, L3 in einen Gleichspannungszwischenkreis, den die beiden Leiter 11, 12 bilden. Die im Zwischenkreis 11, 12 anliegende Gleichspannung wird im nachgeschalteten Wechselrichter 21 wieder in eine hochfrequente Wechselspannung übersetzt, welche anschließend einer Schweißtransformatoreinheit 22 zugeführt ist, von wo sie über Schweißelektroden 23 auf ein zu bearbeitendes Werkstück 1 gebracht wird. Kern des Wechselrichters 21 sind vier Leistungshalbleiterschalter 211 bis 214 mit jeweils zugeordneten Treibern 215 bis 218. Zur Steuerung der Leistungshalbleiterschalter 211 bis 214 sind die Treiber 215 bis 218 mit einer Schweißsteuerung 24 verbunden. An die Schweißsteuerung 24 angeschlossen ist weiterhin eine Induktionsleiterschleife 10, wie sie anhand der Figuren 2 und 3 beschrieben ist. Die Leiterschleife 10 befindet sich auf der Oberseite einer Leiterplatte 25. Auf deren Unterseite, gegenüber der Leiterschleife 10 sind die den Zwischenkreis bildenden Leiter 11, 12 geführt. Innerhalb der Schweißsteuerung befindet sich eine Schaltung gemäß Figur 3. Die Erfassungseinrichtung 10, 11, 12, 24, 25 dient in dieser Anwendung dazu, auftretende Überströme zu erkennen und ggf. ein Abschaltung der Leistungshalbleiterschalter 211 bis 214 herbeizuführen. Erkannt werden insbesondere Überströme, welche durch Kurzschlüsse im Schweißkreis bedingt sind.

Die anhand Figur 4 veranschaulichte Überstromüberwachung läßt sich auf viele andere Schaltungen übertragen. Insbesondere eignet sie sich auch für frequenzumrichterbetriebene Antriebsanordnungen, um darin etwa durch Zwischenkreiskurzschlüsse, Kurzschlüsse in der Motorwicklung oder der Motorzuleitung verursachte Überströme frühzeitig zu erkennen.

Die Induktionsschleife 10 liefert ein zur zeitlichen Änderung des gemessenen Stromes proprotionales Signal der Form dI/dt. Ist die Kenntnis des Stromwertes selbst erwünscht, kann dies in einfacher Weise durch Einbeziehung eines Integrationsgliedes in die Schaltung realisiert werden.

## Patentansprüche

1. Einrichtung zum Erfassen eines Wechselstromes im Gleichspannungszwischenkreis einer Schweißanlage mit Hilfe einer in einer Spule induzierten Spannung, welche ein Maß für den in den Leitern (11,12) des Gleichspannungszwischenkreises fließenden Wechselstrom ist,
**dadurch gekennzeichnet, dass**
auf der Oberfläche einer Leiterplatte (13,25) zwei flächige Leiterbahnen (11,12) aufgebracht sind, worin ein zu messender Strom (Iz1, Iz2) fließt, und welche den Gleichspannungszwischenkreis einer Schweißanlage bilden, und dass auf der gegenüberliegenden Oberfläche (18) der Leiterplatte (13,25) eine flächige, in sich mehrfach gewundene, Leiterschleife (10, 101, 102) aufgebracht ist, in welche die Stromänderung (dIz1/dt, dIz2/dt) eine Spannung induziert, wobei der Außendurchmesser (D2) der Leiterschleife (10, 101, 102) abhängig von der Leiterplattendicke (D3) derart gewählt ist, dass die Windungen der Leiterschleife (10, 101, 102) von dem die Leiterbahnen (11, 12) umgebenden Magnetfeld sicher durchdrungen werden.

2. Einrichtung nach Anspruch 1, wobei die Einrichtung eingangsseitig anschließbar ist an eine Gleichrichtereinheit (20) zur Überführung eines dreiphasigen Eingangswechselstromes (L1, L2, L3) in einen von zwei Leitern (11,12) gebildeten Gleichspannungszwischenkreis.

3. Umrichter mit Gleichspannungszwischenkreis (11, 12) mit einer Gleichrichtereinheit (20) und einem Wechselrichter (21) zur Erzeugung einer Wechselspannung aus der im Zwischenkreis (11,12) anliegenden Gleichspannung, wobei der Zwischenkreis (11, 12) auf Überströme hin überwacht wird, wobei zur Erkennung eines im Zwischenkreis (11,12) fließenden Überstromes eine Anordnung gemäß Anspruch 1 eingesetzt ist.

4. Schweißanlage mit Gleichrichtereinheit (20) wobei an die Gleichrichtereinheit (20) eine Einrichtung nach Anspruch 1 oder 2 angeordnet ist.

5. Schweißanlage mit eingangsseitiger Gleichrichtereinheit (2) zur Überführung eines dreiphasigen Eingangswechselstromes (L1, L2, L3) in einen von zwei Leitern (11,12) gebildeten Gleichspannungszwischenkreis, wobei die im Gleichspannungszwischenkreis anliegende Gleichspannung einem dem Gleichspannungszwischenkreis nachgeschalteten Wechselrichter (21) zugeführt ist, welcher die im Zwischenkreis anliegende Gleichspannung in eine hochfrequente Wechselspannung übersetzt, wobei der Wechselrichter (21) vier Leistungshalbleiterschalter (211 bis 214) umfasst mit jeweils zugeordneten Treibern (215 bis 218), welche zur Steuerung der Leistungshalbleiter mit einer Schweißsteuerung (24) verbunden sind, wobei eine Einrichtung nach Anspruch 1 oder 2 vorgesehen ist, deren Spule (10, 101, 102) an die Steuerung (24) angeschlossen ist, welche bei Auftreten eines Überstromes die Leistungshalbleiter abschaltet.

6. Gleichspannungszwischenkreis für eine Schweißanlage mit Einrichtung nach Anspruch 1 oder 2.

## Claims

1. Device for detecting an alternating current in the DC voltage intermediate circuit of a welding assembly with the aid of a voltage induced in a coil, which voltage is a measure of the alternating current flowing in the conductors (11, 12) of the DC voltage intermediate circuit, **characterized in that** two flat conductor tracks (11, 12) are applied on the surface of a printed circuit board (13, 25), in which conductor tracks a current (Iz1, Iz2) to be measured flows, and which conductor tracks form the DC voltage intermediate circuit of a welding assembly, and **in that** a flat conductor loop (10, 101, 102), which has been wound a plurality of times and into which the change in current (dIz1/dt, dIz2/dt) induces a voltage, is applied on the opposite surface (18) of the printed circuit board (13, 25), the outer diameter (D2) of the conductor loop (10, 101, 102) being selected depending on the printed circuit board thickness (D3) in such a way that the magnetic field surrounding the conductor tracks (11, 12) safely passes through the turns of the conductor loop (10, 101, 102).

2. Device according to Claim 1, the device being capable of being connected on the input side to a rectifier unit (20) for transferring a three-phase input alternating current (L1, L2, L3) into a DC voltage intermediate circuit formed by two conductors (11, 12).

3. Converter with a DC voltage intermediate circuit (11, 12) with a rectifier unit (20) and an inverter (21) for generating an AC voltage from the DC voltage present in the intermediate circuit (11, 12), the intermediate circuit (11, 12) being monitored for overcurrents, an arrangement according to Claim 1 being used to identify an overcurrent flowing in the intermediate circuit (11, 12).

4. Welding assembly with a rectifier unit (20), a device according to Claim 1 or 2 being arranged at the rectifier unit (20).

5. Welding assembly with an input-side rectifier unit (2) for transferring a three-phase input alternating current (L1, L2, L3) into a DC voltage intermediate circuit formed by two conductors (11, 12), the DC voltage present in the DC voltage intermediate circuit being supplied to an inverter (21), which is connected downstream of the DC voltage intermediate circuit and converts the DC voltage present in the intermediate circuit into a high-frequency AC voltage, the inverter (21) comprising four power semiconductor switches (211 to 214), with respectively associated drivers (215 to 218), which are connected to a welding controller (24) for the purpose of controlling the power semiconductors, a device according to Claim 1 or 2 being provided whose coil (10, 101, 102) is connected to the controller (24), which disconnects the power semiconductors in the event of the occurrence of an overcurrent.

6. DC voltage intermediate circuit for a welding assembly with a device according to Claim 1 or 2.

## Revendications

1. Installation pour mesurer un courant alternatif dans un circuit intermédiaire à tension continue d'une installation de soudage à l'aide d'une tension induite dans une bobine et qui est une mesure du courant alternatif passant dans les conducteurs (11,12) du circuit intermédiaire à tension continue,
**caractérisée en ce que**
la surface supérieure d'une plaque de circuit (13,25) comporte deux chemins conducteurs plats (11,12), traversés par un courant à mesurer (Iz1, Iz2) et qui constituent le circuit intermédiaire à tension continue d'une installation de soudage, et
sur la face opposée (18) de la plaque de circuit (13,25) on a une boucle conductrice (10,101,102) plate, à plusieurs spires, dans laquelle la variation d'intensité (dIz1/dt, dIz2/dt) induit une tension,
le diamètre extérieur D2 de la boucle conductrice (10,101,102) étant choisi en fonction de l'épaisseur D3 de la plaque de circuit de façon que les spires de la boucle conductrice (10,101,102) soient traversées avec certitude par le champ magnétique entourant les chemins conducteurs (11,12).

2. Installation selon la revendication 1, qui peut être reliée par son entrée à un redresseur (20) pour fournir un courant alternatif d'entrée L1, L2, L3 triphasé au circuit intermédiaire à tension continue formé par l'un des deux conducteurs (11,12).

3. Onduleur comportant un circuit intermédiaire à tension continue (11,12) et ayant un redresseur (20) et un onduleur (21) pour générer une tension alternative à partir de la tension continue appliquée au circuit intermédiaire (11,12), dans lequel on surveille les surintensités, et pour détecter une surintensité dans le circuit intermédiaire (11,12) on utilise un dispositif selon la revendication 1.

4. Installation de soudage comportant un redresseur (20) qui comporte une installation selon les revendications 1 ou 2.

5. Installation de soudage comportant en entrée un redresseur (2) pour transférer un courant alternatif d'entrée, triphasé L1, L2, L3 vers un circuit intermédiaire à tension continue, formé de deux conducteurs (11,12), la tension continue appliquée au circuit intermédiaire à tension continue étant fournie à un onduleur (21) en aval du circuit intermédiaire à tension continue et cet onduleur transforme la tension continue appliquée au circuit intermédiaire en une tension alternative haute fréquence,
l'onduleur (21) comprenant quatre commutateurs semi-conducteurs de puissance (211-214) avec chaque fois des pilotes associés (215-218) reliés à une commande de soudage (24) pour commander les semi-conducteurs de puissance, et
une installation selon la revendication 1 ou la revendication 2 étant prévue dont la bobine (10,101 et 102) est reliée à la commande (24) qui coupe les semi-conducteurs de puissance en cas de surintensité.

6. Circuit intermédiaire à tension continue pour une installation de soudage équipée d'un dispositif selon les revendications 1 ou 2.
